# EUROPÄISCHE PATENTANMELDUNG

(11) **EP 1 388 376 A2**
(43) Veröffentlichungstag der Anmeldung: **11.02.2004**
(21) Anmeldenummer: 03018106.9
(22) Anmeldetag: 08.08.2003
(51) Int. Cl.: B08B 7/00, H01L 21/00, D06F 43/00

(54) **Reinigung mit CO2 und N2O**

(30) Priorität: 09.08.2002 DE 10236493; 09.08.2002 DE 10236491; 09.08.2002 DE 10236485
(71) Anmelder: MESSER GRIESHEIM GmbH, 65933 Frankfurt am Main (DE)
(72) Erfinder: Donnerhack, Andreas, Dr., 47799 Krefeld (DE); Volker, Wolfgang, 47918 Tönisvorst (DE)

(57) **Zusammenfassung**

Das Reinigungsmittel enthält Kohlendioxid (CO₂) und mindestens 50 Vol.-% Distickstoffmonoxid (N₂O). In dem Reinigungsverfahren wird Kohlendioxid, das zumindest zeitweise mindestens 50 Vol.-% Distickstoffmonoxid enthält, oder Distickstoffmonoxid, das zumindest zeitweise mindestens 50 Vol.-% Kohlendioxid enthält, als Reinigungsmittel mit einem Reinigungsgut wie Textilien, textilartige Stoffe, Folien, Kunststoffteile, Metallteile, Teile aus Keramik, Verbundstoffe, Kunststofffasern, Naturfasern, Glasteile oder Glasoberflächen, strukturierte Oberflächen von Materialien wie Textilien oder ähnlichen Materialien und Formteilen oder Substratoberflächen wie Keramik-, Kunststoff-, Metall- oder Halbleiteroberflächen in Kontakt gebracht.

## Beschreibung

Die Erfindung betrifft ein Reinigungsmittel, enthaltend CO₂ und N₂O, ein Reinigungsverfahren mit CO₂ und N₂O und eine Verwendung des Reinigungsmittels.

Bekannt ist die Trockenreinigung mit überkritischem Kohlendioxid (CO₂). Solche Reinigungsverfahren sind beispielsweise in US 6280481, US 6299652, US 2001013148 und WO 0187505 beschrieben.

Dem verdichteten Kohlendioxid werden üblicherweise Zusätze wie Tenside, Lösemittel oder andere Hilfsstoffe beigefügt. Diese zum Teil nicht flüchtigen Zusätze müssen von dem Reinigungsgut wieder entfernt werden, was in der Regel einen zusätzlichen Aufwand bedeutet.

Ein Verfahren zur Reinigung von Halbleiterscheiben mittels verflüssigter Gase ist aus der DE 695 23 208 T2 bekannt.

Ein Verfahren zur Reinigung von Substratoberflächen wie Halbleiteroberflächen mittels überkritischen Lösemitteln, z.B. Kohlendioxid, ist in der DE 199 42 282 A1 (interne Bezeichnung MG 2260) beschrieben. Die Reinigung von Halbleiteroberflächen mittels überkritischem Kohlendioxid ist auch aus der US 2002014257 oder der EP 0836895 A2 bekannt.

Der Erfindung liegt die Aufgabe zugrunde, ein alternatives Reinigungsmittel und ein alternatives Reinigungsverfahren zur Trockenreinigung verschiedenster Materialien bereit zu stellen. Der Erfindung liegt die weitere Aufgabe zugrunde, ein alternatives Reinigungsverfahren für Substratoberflächen wie Halbleiteroberflächen, insbesondere von Wafer-Oberflächen, bereit zu stellen.

Gelöst wurde die Aufgabe durch ein Reinigungsmittel mit den in Anspruch 1 beschriebenen Merkmalen.

Das Reinigungsmittel gemäß der Erfindung enthält Kohlendioxid (CO₂) und mindestens 50 Vol.-% Distickstoffmonoxid (N₂O), das auch als Lachgas bezeichnet wird. In der Regel besteht das Stoffgemisch aus Kohlendioxid (CO₂) und Distickstoffmonoxid, vorzugsweise aus einem N₂O-Anteil von 50 bis 99 Vol.-%, besonders bevorzugt aus einem N₂O-Anteil von 50 bis 95 Vol.-%, Rest CO₂ (zusammen 100 Vol.-%), insbesondere einem N₂O-Anteil von 60 bis 95 Vol.-%, Rest CO₂. Die Konzentrationsangaben (Vol.-%) beziehen sich auf die Konzentrationen der Komponenten des Stoffgemisches bei Normalbedingungen (1 bar absolut, 20 °C).

Das Reinigungsmittel wird im allgemeinen als Gasgemisch, als Flüssigkeit oder in überkritischem Zustand, vorzugsweise als verdichtetes Gasgemisch oder in überkritischem Zustand, eingesetzt. Das Reinigungsmittel wird vorzugsweise wie übliche Kohlendioxid-Phasen bei der Trockenreinigung eingesetzt. Der Einsatz des Reinigungsmittels in überkritischem Zustand erfolgt beispielsweise wie in der US 6280481, US 6299652, US 2001013148 und WO 0187505 beschrieben, worauf hiermit Bezug genommen wird.

Das Reinigungsmittel kann ein oder mehrere Zusatzstoffe und/oder Modifier enthalten. In diesen Fällen sind die Zusatzstoffe in der Regel in sehr geringer Konzentration enthalten. Zusatzstoffe sind z.B. Tenside, oberflächenaktive Stoffe. Auch der Zusatz von anorganischen Lösemitteln wie Wasser oder organischen Lösemitteln wie Alkohole (z.B. Methanol, Ethanol, Propanol, Isopropanol) oder lineare oder verzweigte Kohlenwasserstoffe (z.B. Propan, Isopropan, Butan, Hexan, Heptan) kann je nach Anwendungsfall in größerer (z.B. Prozentbereich wie 1 bis 10 Gewichtsprozent) oder kleinerer Menge (z.B. Spurenbereich oder ppm-Bereich wie 10 bis 1000 ppm; 1ppm = 10⁻⁶ g pro g) vorteilhaft sein.

Die Löse- bzw. Reinigungseigenschaften des Reinigungsmittels können auch zusätzlich mit Hilfe von sogenannten Modifiern angepaßt werden. Als Modifier werden z.B. eingesetzt:
SO₃, H₂SO₄ (verdünnt oder konzentriert);
NH₃, NH₃ aq, (verdünnt oder konzentriert);
H₂O, Alkohole, Ether, Ketone;
HCI, HCI aq (verdünnt oder konzentriert);
HF, HF aq (verdünnt oder konzentriert);
H₂O₂ (verdünnt oder konzentriert);
O₃, Ozon.

Bevorzugt werden Reinigungsmittel, die aus Kohlendioxid und Distickstoffmonoxid bestehen und keine Zusatzstoffe oder Modifier enthalten, die Rückstände hinterlassen. Das Gemisch mit Kohlendioxid und mindestens 50 Vol.-% Distickstoffmonoxid ist vorteilhaft in vielen Anwendungsbereichen.

Das Stoffgemisch für das Reinigungsmittel wird in der Regel als druckverflüssigte Phase in einem Druckgasbehälter bereitgestellt. Druckgasbehälter sind beispielsweise Druckgasflaschen, Druckgaspatronen (Kleinpatronen) oder Druckdosen.

Kohlendioxid und Distickstoffmonoxid sind ungiftig, unbrennbar und physiologisch unbedenklich. Sie sind bereits im Medizin- und/oder Lebensmittelbereich etabliert.

Ein weiterer Gegenstand der Erfindung ist ein Reinigungsverfahren, bei dem Kohlendioxid und Distickstoffmonoxid drucklos, unter Druck, druckverflüssigt, kälteverflüssigt oder in überkritischem Zustand mit dem Reinigungsgut in Kontakt gebracht werden. Vorzugsweise wird ein Gemisch von Kohlendioxid und mindestens 50 Vol.-% Distickstoffmonoxid als Reinigungsmittel eingesetzt.

Das Reinigungsverfahren dient beispielsweise zur Reinigung oder Behandlung von Textilien, textilartigen Stoffen (z.B. Non-wovens, Vlies, Filz), Folien, Kunststoffteilen, Metallteilen, Teilen aus Keramik, Verbundstoffen, Kunststofffaser, Naturfaser, Glasteilen oder Glasoberflächen, insbesondere zur Reinigung von strukturierten Oberflächen von Materialien wie Textilien oder ähnlichen Materialien und Formteilen, ferner zur Reinigung von Substratoberflächen wie Keramik-, Kunststoff-, Metall- oder Halbleiteroberflächen.

Die Substratoberflächen sind in der Regel Oberflächen von Gegenständen, z. B. Scheiben, flachen Teilen, Bauteilen, insbesondere von Vorstufen zu elektronischen Bauteilen, fertigen elektronischen Bauteilen, Vor-, Zwischen- und Endprodukte bei der Halbleiterfertigung (z. B. bei der Wafer-Produktion).

Die Behandlung des Reinigungsgutes erfolgt vorzugsweise in geschlossenen Systemen unter Verwendung eines Gemisches von Kohlendioxid (CO₂) und Distickstoffmonoxid (N₂O) in flüssiger, gasförmiger oder überkritischer Phase.

In dem Verfahren werden Kohlendioxid und Distickstoffmonoxid als Reinigungsmittel, insbesondere als Kombinationsreinigungsmittel zur gleichzeitigen, getrennten oder zeitlich abgestuften Anwendung eingesetzt.

Besonders vorteilhaft ist die Verwendung von Distickstoffmonoxid (N₂O) bei der Trockenreinigung mit Kohlendioxid. Insbesondere wird die Trockenreinigung mit Kohlendioxid durch die Zudosierung von Distickstoffmonoxid verbessert. In einer Verfahrensvariante wird beispielsweise zu anfänglich reinem Kohlendioxid Distickstoffmonoxid zudosiert. Die zudosierte Distickstoffmonoxid-Konzentration in dem erzeugten Gemisch beträgt mindestens zeitweise mindestens 50 Vol.-% Distickstoffmonoxid. Das Gemisch liegt als Gas, Flüssigkeit oder überkritische Phase vor.

Als Reinigungsmittel dienen z.B. vorgefertigte Gemische, insbesondere in Druckgasbehältern bereitgestellte Gasgemische, die z.B. aus Kohlendioxid und Distickstoffmonoxid bestehen, oder Gemische von Kohlendioxid und Distickstoffmonoxid, die vorort (in situ), in der Regel in dem Reinigungssystem (z.B. in oder an der Reinigungseinrichtung für das Reinigungsgut) erzeugt werden. Beispielsweise wird einem Kohlendioxidstrom kontinuierlich oder diskontinuierlich Distickstoffmonoxid zugemischt. Vorbestimmte Mengen von Distickstoffmonoxid werden z.B. über Steuereinrichtungen und Regeleinrichtungen und insbesondere steuerbare Ventile dem Kohlendioxid zudosiert. Die Dosierung von Distickstoffmonoxid erfolgt beispielsweise in einer oder mehreren Reinigungsphasen (Verfahrensschritten) des Reinigungsverfahrens.

In dem Verfahren wird Kohlendioxid, z.B. mittels einer gesteuerten Dosiereinrichtung, Distickstoffmonoxid zugeführt oder vice versa. Druck und Temperatur in dem System sind zu wählen, je nachdem in gasförmiger, flüssiger oder überkritischer Phase gearbeitet wird.

Die Modifier werden in aller Regel mit Hilfe von Hochdruckdosierpumpen dem Reinigungsmittel beigemischt. Die Konzentrationen bewegen sich in der Regel unterhalb von jeweils 1 Gew.-%. Die Modifier werden im allgemeinen nur zeitweise, z.B. in einem oder mehreren Reinigungsschritten, in dem Reinigungsverfahren eingesetzt.

Vorteilhaft wird das Verfahren mit einer Verfahrensstufe zur Abtrennung von Verunreinigungen aus dem Reinigungsmittel während der Reinigung des Reinigungsgutes oder in einem vorangehenden oder nachfolgenden Verfahrensschritt kombiniert. Besonders vorteilhaft ist ein Kreislaufsystem, bei dem das Reinigungsmittel zwischen einer Reinigungseinrichtung für das Reinigungsgut und einer Reinigungseinrichtung für das Reinigungsmittel geführt wird. Beispielsweise wird das Reinigungsmittel zwischen den Einrichtungen kontinuierlich oder diskontinuierlich umgepumpt. Das Kreislaufsystem arbeitet z.B. mit flüssigem oder überkritischem Reinigungsmittel.

Die Reinigungseinrichtung für das Reinigungsmittel ist z.B. ein Filter, Adsorber oder Absorber, insbesondere eine oder mehrere Durchflußpatronen mit mindestens einem Reinigungsmaterial wie einem Filtermaterial, Adsorbermaterial oder Absorbermaterial. Das Reinigungsmaterial dient insbesondere zur Abtrennung von Verunreinigungen wie in dem Reinigungsmittel löslichen Stoffen, insbesondere Fett oder fettartigen Stoffen. Adsorbermaterial oder Absorbermaterial, auch Adsorptionsmittel oder Absorptionsmittel genannt, sind z.B. Aktivkohlen oder Polymerstoffe (Kunststoffe, z.B. makroretikuläre StyrolCopolymere). Geeignete Adsorptionsmittel oder Absorptionsmittel zur Bindung von Verunreinigungen wie Fett sind dem Fachmann bekannt. Die Regenerierung des Reinigungsmittels durch Abtrennung von Verunreinigungen mittels einer Reinigungseinrichtung bietet sich insbesondere an bei dem Einsatz von Reinigungsmitteln, die keine Additive wie Tenside oder andere nichtflüchtige Additive enthalten. Die Regenerierung des Reinigungsmittels z.B. in einem Kreislaufsystem ist vorteilhaft insbesondere bei Reinigungsmitteln, die aus Kohlendioxid und Distickstoffmonoxid bestehen.

## Patentansprüche

1. Reinigungsmittel, enthaltend Kohlendioxid und mindestens 50 Vol.-% Distickstoffmonoxid.

2. Reinigungsmittel nach Anspruch 1, **gekennzeichnet durch** einen Anteil von Distickstoffmonoxid im Bereich von 50 bis 99 Vol.-%, Rest Kohlendioxid.

3. Reinigungsmittel nach einem der vorangehenden Ansprüche, **dadurch gekennzeichnet, daß** das Reinigungsmittel als druckverflüssigtes Gas vorliegt.

4. Reinigungsmittel nach einem der vorangehenden Ansprüche, **dadurch gekennzeichnet, daß** das Reinigungsmittel in gasförmiger, flüssiger oder überkritischer Phase vorliegt.

5. Reinigungsverfahren, **dadurch gekennzeichnet, daß** Kohlendioxid, das zumindest zeitweise mindestens 50 Vol.-% Distickstoffmonoxid enthält, oder Distickstoffmonoxid, das zumindest zeitweise mindestens 50 Vol.-% Kohlendioxid enthält, als Reinigungsmittel mit einem Reinigungsgut wie Textilien, textilartige Stoffe, Folien, Kunststoffteile, Metallteile, Teile aus Keramik, Verbundstoffe, Kunststofffasern, Naturfasern, Glasteile oder Glasoberflächen, strukturierte Oberflächen von Materialien wie Textilien oder ähnlichen Materialien und Formteilen oder Substratoberflächen wie Keramik-, Kunststoff-, Metall- oder Halbleiteroberflächen in Kontakt gebracht wird.

6. Verfahren nach Anspruch 5, **dadurch gekennzeichnet, daß** das Reinigungsmittel in gasförmiger, druckverflüssigter oder überkritischer Phase eingesetzt wird.

7. Verfahren nach Anspruch 5 oder 6, **dadurch gekennzeichnet, daß** das Reinigungsmittel ein oder mehrere Zusatzstoffe und/oder einen oder mehrere Modifier enthält.

8. Verfahren nach einem der Ansprüche 5 bis 7, **dadurch gekennzeichnet, daß** das Reinigungsmittel einer Reinigungseinrichtung für das Reinigungsmittel zugeführt wird.

9. Verfahren nach einem der Ansprüche 5 bis 8, **dadurch gekennzeichnet, daß** eine Zudosierung von Distickstoffmonoxid und/oder Kohlendioxid zum Reinigungsmittel während dem Kontakt mit dem Reinigungsgut oder in mindestens einem Verfahrensschritt mittels einer Steuer- und/oder Regelungseinrichtung erfolgt.

10. Verwendung eines Stoffgemisches, enthaltend Kohlendioxid und mindestens 50 Vol.-% Distickstoffmonoxid zum Reinigen oder zur Behandlung von Textilien, textilartigen Stoffen, Folien, Kunststoffteilen, Metallteilen, Teilen aus Keramik, Verbundstoffen, Kunststofffaser, Naturfaser, Glasteilen oder Glasoberflächen, insbesondere zur Reinigung von strukturierten Oberflächen von Materialien wie Textilien oder ähnlichen Materialien und Formteilen, von Substratoberflächen wie Keramik-, Kunststoff-, Metall- oder Halbleiteroberflächen.
